# EUROPEAN PATENT APPLICATION

(11) **EP 4 769 483 A1**
(43) Date of publication of application: **01.07.2026**
(21) Application number: 24856118.5
(22) Date of filing: 18.06.2024
(51) Int. Cl.: H01L 21/304, H01L 21/306

(54) **SUBSTRATE PROCESSING DEVICE AND SUBSTRATE PROCESSING METHOD**

(30) Priority: 21.08.2023 JP 2023134039
(71) Applicant: SCREEN Holdings Co., Ltd., Kyoto-shi, Kyoto 602-8585 (JP)
(72) Inventor: SHIMIZU, Shinji, Kyoto-shi, Kyoto 602-8585 (JP)
(74) Representative: Kilian Kilian & Partner mbB
(86) International application number: PCT/JP2024/021974
(87) International publication number: WO 2025/041423

(57) **Abstract**

A substrate processing apparatus (100) includes a nozzle (136), a supply portion (135), a liquid return portion (160), a near-infrared light source (140), a near-infrared imaging portion (150), and a controlling portion (102). The nozzle (136) supplies a processing liquid (L) to a substrate (W). The supply portion (135) supplies the processing liquid (L) to the nozzle (136). The near-infrared light source (140) irradiates a region including a tip (136a) of the nozzle (136) with near-infrared rays. The controlling portion (102) stops the supply of the processing liquid (L) by the supply portion (135), and returns the processing liquid (L) in the nozzle (136) to the upstream side by the liquid return portion (160). The controlling portion (102) captures an image of the processing liquid (L) moving to the upstream side in the nozzle (136) by the near-infrared imaging portion (150). The controlling portion (102) specifies the position of the outer edge of the processing liquid (L) in the nozzle (136) based on the captured image.

## Description

### Technical Field

The present invention relates to a substrate processing apparatus and a substrate processing method.

### Background Art

A substrate processing apparatus that supplies a processing liquid to a substrate to process the substrate is known (see, for example, Patent Literature 1). Patent Literature 1 describes a substrate processing apparatus including a supply nozzle that supplies a processing liquid to a substrate, a pipe that serves as a liquid supply path that supplies the processing liquid to the supply nozzle, and a supply valve that is located in the pipe. The supply valve has a function as a suck back valve. The supply valve has a role of generating a negative pressure in the suction chamber and drawing the leading surface of the processing liquid from the tip of the supply nozzle when the processing liquid is not supplied from the supply nozzle.

### Citation List

### Patent Literature

Patent Literature 1: JP 2020-126886 A

### Summary of Invention

### Technical Problem

In the substrate processing apparatus as described in Patent Literature 1, when the processing liquid is not supplied from the supply nozzle, the suck back valve retracts the leading surface of the processing liquid from the tip of the supply nozzle to prevent the processing liquid from falling from the supply nozzle.

However, it is difficult to confirm whether or not the processing liquid in the supply nozzle is normally returned when the suck back valve is switched. Specifically, since a processing liquid used for processing the substrate is generally transparent, a general CCD camera cannot detect the processing liquid. Therefore, the processing liquid in the supply nozzle may not be specified with high accuracy. Hereinafter, returning the processing liquid in the nozzle to the upstream side may be referred to as a suck back.

The present invention has been made in view of the above problems, and an object thereof is to provide a substrate processing apparatus and a substrate processing method capable of specifying a processing liquid in a processing liquid nozzle during a suck back with high accuracy.

### Solution to Problem

According to one aspect of the present invention, a substrate processing apparatus includes a substrate holding portion, a processing liquid nozzle, a supply portion, a liquid return portion, a near-infrared light source, a near-infrared imaging portion, and a controlling portion. The substrate holding portion holds a substrate and rotates the substrate. The processing liquid nozzle supplies a processing liquid to an upper surface of the substrate. The supply portion supplies the processing liquid to the processing liquid nozzle. The liquid return portion returns the processing liquid in the processing liquid nozzle to an upstream side. The near-infrared light source irradiates a region including a tip of the processing liquid nozzle with near-infrared rays. The near-infrared imaging portion generates a captured image obtained by capturing an image of the processing liquid irradiated with the near-infrared rays from the near-infrared light source. The controlling portion controls the supply portion, the liquid return portion, and the near-infrared imaging portion. The controlling portion stops the supply of the processing liquid by the supply portion, and returns the processing liquid in the processing liquid nozzle to the upstream side by the liquid return portion. The controlling portion causes the near-infrared imaging portion to capture an image of the processing liquid moving to the upstream side in the processing liquid nozzle. The controlling portion specifies a position of an outer edge of the processing liquid in the processing liquid nozzle based on the captured image.

In a preferred embodiment, the controlling portion specifies a position of an end edge of the processing liquid on a downstream side in the processing liquid nozzle based on the captured image.

In a preferred embodiment, the controlling portion calculates a speed at which the processing liquid moves to an upstream side in the processing liquid nozzle based on the specified position of the end edge of the processing liquid on the downstream side.

In a preferred embodiment, the controlling portion captures an image of the processing liquid moving to the upstream side in the processing liquid nozzle by the near-infrared imaging portion when a predetermined time has elapsed since the liquid return portion starts returning of the processing liquid in the processing liquid nozzle to the upstream side. The controlling portion calculates the speed based on the specified position of the end edge of the processing liquid on the downstream side and the predetermined time.

In a preferred embodiment, the controlling portion calculates a distance from a tip of the processing liquid nozzle to the end edge of the processing liquid on the downstream side based on the captured image. The controlling portion calculates the speed based on the calculated distance and the predetermined time.

In a preferred embodiment, the controlling portion captures an image of the processing liquid moving to the upstream side in the processing liquid nozzle a plurality of times at predetermined time intervals by the near-infrared imaging portion. The controlling portion calculates the speed based on a position of the end edge of the processing liquid on the downstream side in the plurality of captured images and the predetermined time.

In a preferred embodiment, the processing liquid nozzle has a liquid flow path through which the processing liquid passes. The controlling portion specifies a center line of the liquid flow path based on the captured image. The controlling portion calculates the speed based on a length of movement of the end edge of the processing liquid on the downstream side along a center line of the liquid flow path and the predetermined time.

In a preferred embodiment, the controlling portion determines the presence or absence of occurrence of abnormality based on the specified position of the outer edge of the processing liquid. The controlling portion changes at least one of a timing of starting returning of the processing liquid to the upstream side and a timing of stopping returning of the processing liquid to the upstream side based on the specified position of the outer edge of the processing liquid when it is determined that the abnormality has occurred.

In a preferred embodiment, the controlling portion specifies the type of the processing liquid based on the captured image.

In a preferred embodiment, the near-infrared light source includes a plurality of near-infrared light sources that emit near-infrared rays having peak wavelengths different from each other. The controlling portion acquires type information indicating the type of the processing liquid. The controlling portion changes the near-infrared light source that irradiates a region including the tip of the processing liquid nozzle based on the acquired type information.

According to another aspect of the present invention, a substrate processing method includes a step of holding a substrate and rotating the substrate, a step of supplying a processing liquid to a processing liquid nozzle and supplying the processing liquid from the processing liquid nozzle to an upper surface of the substrate, a step of returning the processing liquid in the processing liquid nozzle to an upstream side after stopping the supply of the processing liquid, a step of irradiating a region including a tip of the processing liquid nozzle with near-infrared rays, a step of generating a captured image obtained by capturing an image of the processing liquid irradiated with the near-infrared rays and moving to the upstream side in the processing liquid nozzle, and a step of specifying a position of an outer edge of the processing liquid in the processing liquid nozzle based on the captured image.

In a preferred embodiment, in the step of specifying, a position of an end edge of the processing liquid on a downstream side in the processing liquid nozzle is specified based on the captured image.

In a preferred embodiment, the substrate processing method includes a step of calculating a speed at which the processing liquid moves to an upstream side in the processing liquid nozzle based on the specified position of the end edge of the processing liquid on the downstream side.

In a preferred embodiment, in the step of generating the captured image, an image of the processing liquid moving to the upstream side in the processing liquid nozzle is captured when a predetermined time has elapsed since the processing liquid in the processing liquid nozzle starts to be returned to the upstream side, and in the step of calculating, the speed is calculated based on the specified position of the end edge of the processing liquid on the downstream side and the predetermined time.

In a preferred embodiment, in the step of calculating, a distance from a tip of the processing liquid nozzle to the end edge of the processing liquid on the downstream side is calculated based on the captured image, and the speed is calculated based on the calculated distance and the predetermined time.

In a preferred embodiment, in the step of generating the captured image, an image of the processing liquid moving to the upstream side in the processing liquid nozzle is captured a plurality of times at predetermined time intervals, and in the step of calculating, the speed is calculated based on a position of the end edge of the processing liquid on the downstream side in the plurality of captured images and the predetermined time.

In a preferred embodiment, in the step of specifying, a center line of a liquid flow path through which the processing liquid passes in the processing liquid nozzle is specified based on the captured image, and in the step of calculating, the speed is calculated based on a length of movement of the end edge of the processing liquid on the downstream side along the center line of the liquid flow path and the predetermined time.

In a preferred embodiment, the substrate processing method includes a step of determining the presence or absence of occurrence of abnormality based on the specified position of the outer edge of the processing liquid, and a step of changing at least one of a timing of starting returning of the processing liquid to the upstream side and a timing of stopping the returning of the processing liquid to the upstream side based on the specified position of the outer edge of the processing liquid when it is determined that the abnormality has occurred.

In a preferred embodiment, in the step of specifying, the type of the processing liquid is specified based on the captured image.

In a preferred embodiment, the near-infrared light source includes a plurality of near-infrared light sources that emit near-infrared rays having peak wavelengths different from each other. The substrate processing method includes a step of acquiring type information indicating the type of the processing liquid, and a step of changing the near-infrared light source that irradiates a region including a tip of the processing liquid nozzle based on the acquired type information.

### Advantageous Effects of Invention

According to the present invention, it is possible to provide a substrate processing apparatus and a substrate processing method capable of specifying a processing liquid in a processing liquid nozzle with high accuracy during a suck back.

### Brief Description of Drawings

[FIG. 1] a schematic plan view of a substrate processing apparatus of an embodiment.
[FIG. 2] a schematic view of a substrate processing unit in the substrate processing apparatus.
[FIG. 3] a block diagram of the substrate processing apparatus.
[FIG. 4] a flowchart of a substrate processing method of the embodiment.
[FIG. 5] a schematic view illustrating a configuration around a liquid return portion of the substrate processing apparatus of the embodiment.
[FIG. 6] a schematic view illustrating a tip portion of a nozzle during a suck back.
[FIG. 7] a schematic view illustrating the tip portion of the nozzle during the suck back.
[FIG. 8] a schematic view illustrating the tip portion of the nozzle during the suck back.
[FIG. 9] a schematic view illustrating the tip portion of the nozzle during the suck back.
[FIG. 10] a schematic view illustrating the tip portion of the nozzle during the suck back.
[FIG. 11] a schematic view illustrating a state in which a processing liquid is separated in the nozzle during the suck back.
[FIG. 12] a flowchart of a substrate processing step in the substrate processing method of the embodiment.
[FIG. 13] a schematic view of a substrate processing unit in a substrate processing apparatus including a plurality of near-infrared light sources.
[FIG. 14] a flowchart of a substrate processing step in an example in which the near-infrared light source includes a plurality of near-infrared light sources.

### Description of Embodiments

Hereinafter, embodiments of a substrate processing apparatus and a substrate processing method according to the present invention will be described with reference to the drawings. It is noted that, in the drawings, the same reference signs are assigned to the same or corresponding portions, and description shall not be repeated. It is noted that, in the present specification, an X-axis, a Y-axis, and a Z-axis orthogonal to each other may be referred to in order to facilitate understanding of the invention. Typically, the X-axis and the Y-axis are parallel to a horizontal direction, and the Z-axis is parallel to a vertical direction.

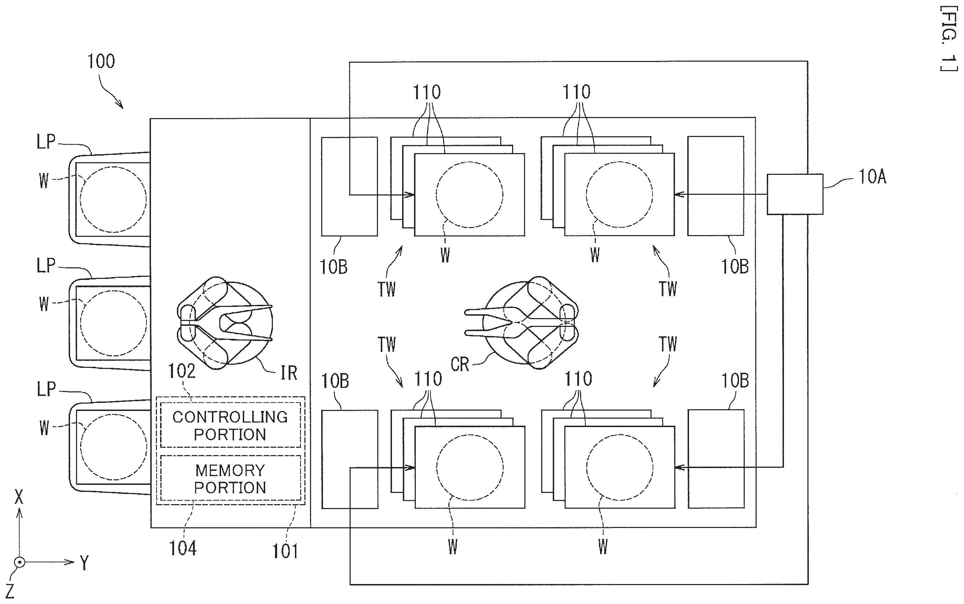

First, a substrate processing apparatus 100 of an embodiment will be described with reference to FIG. 1. FIG. 1 is a schematic plan view of the substrate processing apparatus 100.

As shown in FIG. 1, the substrate processing apparatus 100 processes a substrate W. The substrate processing apparatus 100 processes the substrate W to perform at least one of etching, surface processing, characteristics imparting, processing film forming, removing at least a portion of a film, and cleaning with respect to the substrate W.

The substrate W is used as a semiconductor substrate. The substrate W includes a semiconductor wafer. For example, the substrate W has a substantially disk shape. Here, the substrate processing apparatus 100 processes the substrates W one by one.

As shown in FIG. 1, the substrate processing apparatus 100 includes a plurality of substrate processing units 110, a fluid cabinet 10A, a fluid box 10B, a plurality of load ports LP, an indexer robot IR, a center robot CR, and a controller 101. The controller 101 controls the load port LP, the indexer robot IR, the center robot CR, and the substrate processing units 110.

Each of the load ports LP stacks and accommodates a plurality of substrates W. The indexer robot IR transports the substrate W between the load port LP and the center robot CR. It is noted that, an installation base (path) on which a substrate W is temporarily placed may be provided between an indexer robot IR and a center robot CR, and a configuration of the apparatus may be such that the substrate W is indirectly transferred between the indexer robot IR and the center robot CR through the installation base. The center robot CR transports the substrate W between the indexer robot IR and the substrate processing unit 110. Each of the substrate processing units 110 discharges a processing liquid onto the substrate W to process the substrate W. The fluid cabinet 10A accommodates the processing liquid. It is noted that the fluid cabinet 10A may accommodate a gas.

The plurality of substrate processing units 110 form a plurality of towers TW (four towers TW in FIG. 1) disposed to surround the center robot CR in plan view. Each tower TW includes substrate processing units 110 (three substrate processing units 110 in FIG. 1) stacked vertically. The fluid boxes 10B correspond to a plurality of towers TW, respectively. The processing liquid in the fluid cabinet 10A passes through any one of the fluid boxes 10B and is supplied to all of the substrate processing units 110 included in the tower TW corresponding to the fluid box 10B. Also, the gas in the fluid cabinet 10A passes through any one of the fluid boxes 10B and is supplied to all of the substrate processing units 110 included in the tower TW corresponding to the fluid box 10B.

The controller 101 controls various operations of the substrate processing apparatus 100. The controller 101 includes a controlling portion 102 and a memory portion 104. The controlling portion 102 includes a processor. The controlling portion 102 includes a central processing unit (CPU), for example. Alternatively, the controlling portion 102 may include a general-purpose calculator.

The memory portion 104 includes a main memory and an auxiliary memory. The main memory is a semiconductor memory, for example. The auxiliary memory is a semiconductor memory and/or a hard disk drive, for example. The memory portion 104 may include a removable medium. The controlling portion 102 executes a computer program stored in the memory portion 104 to execute a substrate processing operation.

The memory portion 104 stores data. The data includes recipe data. The recipe data includes information indicating a plurality of recipes. Each of the plurality of recipes defines processing contents and processing procedures of the substrate W.

In addition, the memory portion 104 may store a luminance value or brightness of the reference processing liquid. Alternatively, the memory portion 104 may store a reference image obtained by capturing an image of the reference processing liquid.

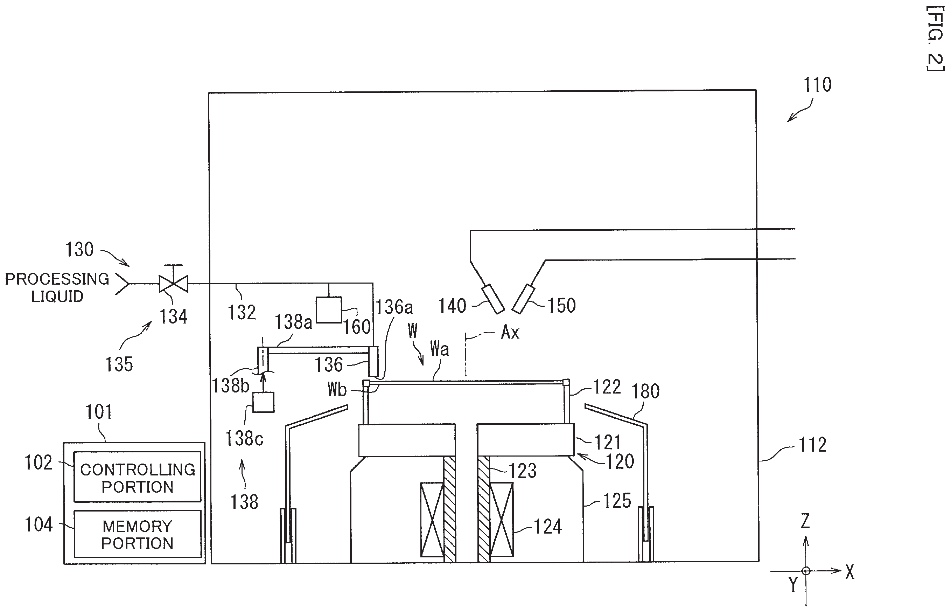

Next, the substrate processing unit 110 in the substrate processing apparatus 100 of the present embodiment will be described with reference to FIG. 2. FIG. 2 is a schematic view of the substrate processing unit 110 in the substrate processing apparatus 100.

The substrate processing unit 110 includes a chamber 112, a substrate holding portion 120, a processing liquid supply portion 130, a near-infrared light source 140, and a near-infrared imaging portion 150. The chamber 112 accommodates the substrate holding portion 120, and at least a part of the processing liquid supply portion 130, the near-infrared light source 140, and the near-infrared imaging portion 150.

The chamber 112 has a substantially box-shaped configuration with an internal space. The chamber 112 accommodates the substrate W. Here, the substrate processing unit 110 is a single substrate processing type that processes the substrates W one by one, and the chamber 112 accommodates the substrates W one by one. The substrate W is accommodated in the chamber 112 and processed in the chamber 112.

The substrate holding portion 120 holds the substrate W. The substrate holding portion 120 horizontally holds the substrate W so that the upper surface (front surface) Wa of the substrate W faces upward and the lower surface (rear surface) Wb of the substrate W faces vertically downward. In addition, the substrate holding portion 120 rotates the substrate W while holding the substrate W. The upper surface Wa of the substrate W may be flattened. Alternatively, the upper surface Wa of the substrate W may be provided with a device surface, or may be provided with a pillar-shaped laminate body provided with a recess. The substrate holding portion 120 rotates the substrate W while holding the substrate W.

For example, the substrate holding portion 120 may be a gripping type that grips an end portion of the substrate W. Alternatively, the substrate holding portion 120 may have an arbitrary mechanism that holds the substrate W from the lower surface Wb. For example, the substrate holding portion 120 may be a vacuum type. In this case, the substrate holding portion 120 horizontally holds the substrate W by suctioning, on an upper surface, a central portion of the lower surface Wb of the substrate W which is the non-device-forming surface. Alternatively, the substrate holding portion 120 may be a combination of the gripping type, in which a plurality of chuck pins are brought into contact with a circumferential end surface of the substrate W, and the vacuum type.

For example, the substrate holding portion 120 includes a spin base 121, a chuck member 122, a shaft 123, an electric motor 124, and a housing 125. The chuck member 122 is provided on the spin base 121. The chuck member 122 chucks the substrate W. Typically, the spin base 121 includes a plurality of chuck members 122.

The shaft 123 is a hollow shaft. The shaft 123 extends in the vertical direction along a rotation axis Ax. The spin base 121 is coupled to an upper end of the shaft 123. The substrate W is placed above the spin base 121.

The spin base 121 has a disk shape. The chuck members 122 horizontally support the substrate W. The shaft 123 extends downward from a central portion of the spin base 121. The electric motor 124 applies a rotation force to the shaft 123. The electric motor 124 rotates the substrate W and the spin base 121 around the rotation axis Ax by rotating the shaft 123 in a rotation direction. The housing 125 surrounds the shaft 123 and the electric motor 124.

The processing liquid supply portion 130 supplies the processing liquid to the substrate W. Typically, the processing liquid supply portion 130 supplies the processing liquid to the upper surface Wa of the substrate W held by the substrate holding portion 120. It is noted that, the processing liquid supply portion 130 may supply a plurality of types of processing liquids to the substrate W.

The processing liquid may be an etching liquid for etching the substrate W. Examples of the etching liquid include, for example, hydrofluoric nitric acid (a mixed liquid of hydrofluoric acid (HF) and nitric acid (HNO₃)), hydrofluoric acid, buffered hydrofluoric acid (BHF), ammonium fluoride, HFEG (a mixed liquid of hydrofluoric acid and ethylene glycol), and phosphoric acid (H₃PO₄). The type of the etching liquid is not particularly limited, and may be, for example, acidic or alkaline.

Alternatively, the processing liquid may be a rinse liquid. Examples of the rinse liquid include, for example, deionized water (DIW), carbonated water, electrolyzed ion water, ozone water, ammonia water, diluted hydrochloric acid water, and reduced water (hydrogen water).

Alternatively, the processing liquid may be an organic solvent. Typically, the volatility of the organic solvent is higher than the volatility of the rinse liquid. Examples of the organic solvent include, for example, isopropyl alcohol (IPA), methanol, ethanol, acetone, hydrofluoro ether (HFE), propylene glycol monoethyl ether (PGEE), and propylene glycol monomethyl ether acetate (propyleneglycol monomethyl ether acetate: PGMEA).

The processing liquid supply portion 130 includes a pipe 132, a valve 134, a nozzle 136, and a moving mechanism 138. It is noted that, the nozzle 136 is an example of a "processing liquid nozzle" of the present invention. A processing liquid from a supply source flows through the pipe 132. The valve 134 opens and closes a flow path in the pipe 132. The nozzle 136 is connected to the pipe 132. In the present preferred embodiment, the pipe 132 and the valve 134 constitute a supply portion 135 that supplies the processing liquid to the nozzle 136. It is noted that, the supply portion 135 may include, for example, a pump (not illustrated) that feeds the processing liquid from a supply source. When the processing liquid flows through the nozzle 136, the nozzle 136 discharges the processing liquid onto the upper surface Wa of the substrate W. The nozzle 136 is preferably configured to be movable with respect to the substrate W.

The pipe 132 and the nozzle 136 are formed of resin. The nozzle 136 transmits near-infrared rays emitted from the near-infrared light source 140. In the present preferred embodiment, the pipe 132 and the nozzle 136 transmit near-infrared rays emitted from the near-infrared light source 140. The pipe 132 and the nozzle 136 are not particularly limited, but are formed of, for example, perfluoroalkoxy alkane (PFA) or polytetrafluoroethylene (PTFE).

The moving mechanism 138 moves the nozzle 136 in the horizontal direction and the vertical direction. Specifically, the moving mechanism 138 moves the nozzle 136 along the circumferential direction around the rotational axis extending in the vertical direction. In addition, the moving mechanism 138 moves up and down the nozzle 136 in the vertical direction.

The moving mechanism 138 includes an arm 138a, a shaft portion 138b, and a driving portion 138c. The arm 138a extends along the horizontal direction. The nozzle 136 is located at the distal end of the arm 138a. The nozzle 136 is located at the distal end of the arm 138a in a posture capable of supplying the processing liquid toward the upper surface Wa of the substrate W held by a chuck member 122. Specifically, the nozzle 136 is coupled to the distal end of the arm 138a and protrudes downward from the arm 138a. A proximal end portion of the arm 138a is coupled to the shaft portion 138b. The shaft portion 138b extends along the vertical direction.

The driving portion 138c includes a rotational driving mechanism and an elevating/lowering driving mechanism. The rotational driving mechanism of the driving portion 138c rotates the shaft portion 138b about the rotational axis to turn the arm 138a about the shaft portion 138b along the horizontal plane. As a result, the nozzle 136 moves along the horizontal plane. Specifically, the nozzle 136 moves along the circumferential direction around the shaft portion 138b. The rotational driving mechanism of the driving portion 138c includes, for example, a motor capable of rotating forward and backward.

The elevating/lowering driving mechanism of the driving portion 138c moves the shaft portion 138b up and down in the vertical direction. When the elevating/lowering driving mechanism of the driving portion 138c moves the shaft portion 138b up and down, the nozzle 136 moves up and down in the vertical direction. The elevating/lowering driving mechanism of the driving portion 138c includes a drive source such as a motor and an elevating/lowering mechanism, and the elevating/lowering mechanism is driven by the drive source to raise or lower the shaft portion 138b. The elevating/lowering mechanism includes, for example, a rack-and-pinion mechanism or a ball screw.

The near-infrared light source 140 emits at least near-infrared rays. The near-infrared light source 140 irradiates a region including a tip 136a of the nozzle 136 with near-infrared rays. The near-infrared light source 140 may irradiate the nozzle 136 and a part of the pipe 132 with near-infrared rays. In addition, the near-infrared light source 140 may irradiate the nozzle 136 and at least a part of the substrate W with near-infrared rays. The near-infrared light source 140 irradiates a region including a portion of, for example, not less than 10 mm and not more than 200 mm on the upstream side (pipe 132 side) from the tip 136a of the nozzle 136 with near-infrared rays.

For example, the near-infrared light source 140 emits near-infrared rays having a wavelength within a range of, for example, not less than 800 nm and not more than 2.5 µm. Typically, the near-infrared light source 140 emits near-infrared rays having a wavelength at least within a range of not less than 800 nm and not more than 1.5 µm. It is noted that, the near-infrared light source 140 may emit visible light together with near-infrared rays.

For example, the near-infrared rays emitted from the near-infrared light source 140 travel linearly along the optical axis. Alternatively, the near-infrared rays emitted from the near-infrared light source 140 travel while spreading around the optical axis. The near-infrared light source 140 is preferably located such that the optical axis of the near-infrared light source 140 passes through the nozzle 136.

The near-infrared imaging portion 150 has a plurality of pixels. The near-infrared imaging portion 150 has sensitivity to at least near-infrared rays. The near-infrared imaging portion 150 receives a component transmitted through and/or reflected by the nozzle 136, the pipe 132, the substrate W, and the like in the near-infrared rays emitted from the near-infrared light source 140, thereby capturing an image of a region including the tip 136a of the nozzle 136 to generate a captured image. Therefore, the near-infrared imaging portion 150 can generate a captured image by capturing an image of the processing liquid irradiated with the near-infrared rays emitted from the near-infrared light source 140.

The near-infrared imaging portion 150 captures an image of a region including the tip 136a of the nozzle 136. The near-infrared imaging portion 150 may capture an image of the nozzle 136 and a part of the pipe 132. In addition, the near-infrared imaging portion 150 may capture an image of the nozzle 136 and at least a part of the substrate W. It is noted that, the near-infrared imaging portion 150 may capture an entire image in the chamber 112. The region whose image is captured by the near-infrared imaging portion 150 may not coincide with the region irradiated by the near-infrared light source 140.

In the near-infrared imaging portion 150, the frame rate may be 30 fps or 60 fps. Alternatively, the frame rate may be 120 fps.

The near-infrared imaging portion 150 may include a short wavelength infra-red (SWIR) image sensor. In this case, for example, the near-infrared imaging portion 150 detects near-infrared rays having a wavelength within a range of not less than 800 nm and not more than 2.5 µm.

It is noted that, the near-infrared imaging portion 150 may have sensitivity to not only near-infrared rays but also visible light. Alternatively, the near-infrared imaging portion 150 may switch and receive near-infrared rays and visible light.

The near-infrared imaging portion 150 captures an image of the surroundings around the imaging optical axis. Typically, the imaging optical axis is positioned at the center of the captured image. For example, the center of the captured image of the near-infrared imaging portion 150 is positioned at the nozzle 136. In this case, the imaging optical axis of the near-infrared imaging portion 150 is positioned at the nozzle 136. Alternatively, the center of the captured image of the near-infrared imaging portion 150 may be positioned on the pipe 132 or the substrate W.

The near-infrared imaging portion 150 generates a captured image obtained by capturing an image of the tip portion including the tip 136a of the nozzle 136. It is preferable that the processing liquid in the nozzle 136 can be specified by the captured image. For example, it is preferable that the position of the outer edge of the processing liquid moving in the nozzle 136 can be specified by the captured image. In addition, for example, it is preferable that the position of the downstream end edge of the processing liquid moving in the nozzle 136 can be specified by the captured image. Alternatively, it is preferable that the outer edge of the processing liquid dropped from the nozzle 136 onto the substrate W can be specified by the captured image. In addition, it is preferable that the position of the outer edge of the processing liquid moving in the pipe 132 can be specified by the captured image.

When the substrate processing unit 110 is viewed in plan view, the optical axis of the near-infrared light source 140 and the imaging optical axis of the near-infrared imaging portion 150 pass through the nozzle 136. In addition, when the substrate processing unit 110 is viewed in plan view, the near-infrared light source 140 and the near-infrared imaging portion 150 may be located on opposite sides with the nozzle 136 interposed therebetween. In addition, when the substrate processing unit 110 is viewed in plan view, the optical axis of the near-infrared light source 140 and the imaging optical axis of the near-infrared imaging portion 150 may coincide with each other or may be parallel to each other. In addition, when the substrate processing unit 110 is viewed in plan view, the optical axis of the near-infrared light source 140 and the imaging optical axis of the near-infrared imaging portion 150 may not be parallel.

Here, the near-infrared light source 140 and the near-infrared imaging portion 150 are located inside the chamber 112. The near-infrared light source 140 and the near-infrared imaging portion 150 may be located to be fixed to each other.

The near-infrared light source 140 and the near-infrared imaging portion 150 may be movable with respect to the substrate W. For example, the near-infrared light source 140 and the near-infrared imaging portion 150 are preferably movable in the horizontal direction and/or the vertical direction according to a moving mechanism controlled by a controlling portion 102. When the near-infrared light source 140 and the near-infrared imaging portion 150 move, the near-infrared light source 140 and the near-infrared imaging portion 150 may be movable independently of each other. Alternatively, the near-infrared light source 140 and the near-infrared imaging portion 150 may be integrally movable.

The processing liquid may contain an organic substance. For example, in an organic substance, a bond such as C-H, C-O, C-N, or C-F absorbs a specific wavelength included in near-infrared rays. Since the absorption amount of a specific wavelength of near-infrared rays is proportional to the amount of a component having a specific bonding group, the abundance of the specific component of the substrate W can be measured based on near-infrared rays reflected from the substrate W.

In the present preferred embodiment, the substrate processing apparatus 100 further includes a liquid return portion 160. The liquid return portion 160 is connected to the pipe 132. The liquid return portion 160 can return (suck back) the processing liquid in the nozzle 136 to the upstream side (pipe 132 side) in a state where the supply of the processing liquid to the nozzle 136 by the supply portion 135 is stopped. The configuration of the liquid return portion 160 will be described later.

The substrate processing apparatus 100 further includes a cup 180. The cup 180 collects the processing liquid scattered from the substrate W. The cup 180 moves up and down. For example, the cup 180 moves up vertically to the side of the substrate W over a period in which the processing liquid supply portion 130 supplies the processing liquid to the substrate W. In this case, the cup 180 collects the processing liquid scattered from the substrate W by the rotation of the substrate W. In addition, when the period during which the processing liquid supply portion 130 supplies the processing liquid to the substrate W ends, the cup 180 moves down vertically from the side of the substrate W.

As described above, a controller 101 includes the controlling portion 102 and the memory portion 104. The controlling portion 102 controls the substrate holding portion 120, the processing liquid supply portion 130, the near-infrared light source 140, the near-infrared imaging portion 150, the liquid return portion 160, and/or the cup 180. In one example, the controlling portion 102 controls the electric motor 124, the valve 134, the moving mechanism 138, the near-infrared light source 140, the near-infrared imaging portion 150, the liquid return portion 160, and/or the cup 180.

According to the substrate processing apparatus 100 of the present preferred embodiment, the near-infrared imaging portion 150 captures an image of the processing liquid irradiated with near-infrared rays from the near-infrared light source 140. Specifically, the image of the processing liquid in the nozzle 136 is captured by the near-infrared imaging portion 150. Typically, the nozzle 136 is transparent and transmits visible light and near-infrared rays. The processing liquid is transparent and transmits visible light. On the other hand, the processing liquid often exhibits relatively strong absorption in the near-infrared region. Therefore, the outer edge of the processing liquid can be specified in the captured image obtained by capturing an image of a region including the tip 136a of the nozzle 136 by the near-infrared imaging portion 150. Specifically, luminance or brightness increases in a portion indicating the nozzle 136, the pipe 132, and the substrate W in the captured image. On the other hand, in a portion indicating the processing liquid in the captured image, the luminance or brightness decreases. Therefore, the outer edge of the processing liquid can be specified in the captured image.

In addition, the processing liquid often exhibits specific absorption in the near-infrared region depending on the type. Therefore, in the captured image obtained by capturing an image of the processing liquid in the nozzle 136 by the near-infrared imaging portion 150, the luminance or brightness of the processing liquid varies depending on the type of the processing liquid. Therefore, the type of the processing liquid can be specified based on the luminance or brightness of the processing liquid in the captured image.

Alternatively, since the wavelength illustrating strong absorption varies depending on the processing liquid, the near-infrared light source 140 may change the wavelength of the emitted near-infrared rays. Thus, the outer edge and the liquid type of the processing liquid can be easily specified.

The substrate processing apparatus 100 of the present embodiment is suitably used for manufacturing a semiconductor device provided with a semiconductor. Typically, in a semiconductor device, a conductive layer and an insulating layer are laminated on a base material. The substrate processing apparatus 100 is suitably used for cleaning and/or processing (for example, etching, characteristic change, and the like) of the conductive layer and/or the insulating layer at the time of manufacturing the semiconductor device.

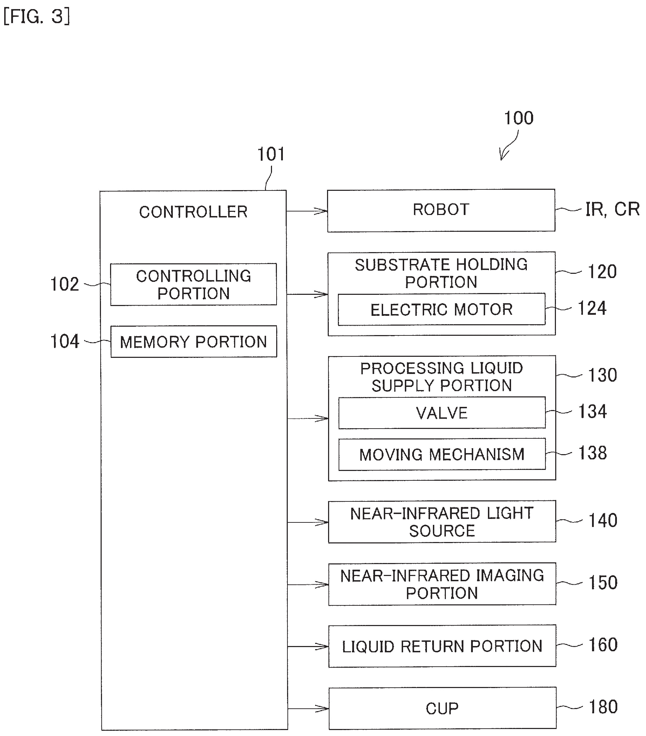

Next, the substrate processing apparatus 100 of the present embodiment will be described with reference to FIGS. 1 to 3. FIG. 3 is a block diagram of the substrate processing apparatus 100.

As illustrated in FIG. 3, the controller 101 controls various operations of the substrate processing apparatus 100. The controller 101 controls the indexer robot IR, the center robot CR, the substrate holding portion 120, the processing liquid supply portion 130, the near-infrared light source 140, the near-infrared imaging portion 150, the liquid return portion 160, and the cup 180. Specifically, the controller 101 controls the indexer robot IR, the center robot CR, the substrate holding portion 120, the processing liquid supply portion 130, the near-infrared light source 140, the near-infrared imaging portion 150, the liquid return portion 160, and the cup 180 by transmitting control signals to the indexer robot IR, the center robot CR, the substrate holding portion 120, the processing liquid supply portion 130, the near-infrared light source 140, the near-infrared imaging portion 150, the liquid return portion 160, and the cup 180.

Also, the memory portion 104 stores a computer program and data. The data includes recipe data. The recipe data includes information indicating a plurality of recipes. Each of the plurality of recipes defines processing details, a processing procedure, and a substrate processing condition of the substrate W. The controlling portion 102 executes a computer program stored in the memory portion 104 to execute a substrate processing operation.

In addition, the recipe data includes type information indicating the type of the processing liquid supplied from the nozzle 136 to the substrate W. In addition, the memory portion 104 stores in advance data in which the type of the processing liquid is associated with the luminance or brightness of the processing liquid in the reference image.

The controlling portion 102 controls the indexer robot IR to transfer the substrate W by the indexer robot IR.

The controlling portion 102 controls the center robot CR to transfer the substrate W by the center robot CR. For example, the center robot CR receives the unprocessed substrate W and carries the substrate W into any one of the plurality of chambers 112. Also, the center robot CR receives the processed substrate W from the chamber 112 and carries out the substrate W.

The controlling portion 102 controls the substrate holding portion 120 to control a start of rotation of the substrate W, a change in rotation speed, and a stop of rotation of the substrate W. For example, the controlling portion 102 can control the substrate holding portion 120 to change a rotation speed of the substrate holding portion 120. Specifically, the controlling portion 102 can change a rotation speed of the substrate W by changing a rotation speed of the electric motor 124 of the substrate holding portion 120.

The controlling portion 102 can control the valve 134 of the processing liquid supplying portion 130 to switch a state of the valve 134 between the open state and the closed state. Specifically, the controlling portion 102 can control the valve 134 of the processing liquid supplying portion 130 to make the valve 134 in the open state, thereby enabling the processing liquid flowing in the piping 132 toward the nozzle 136 to pass therethrough. Also, the controlling portion 102 can control the valve 134 of the processing liquid supplying portion 130 to make the valve 134 in the closed state, thereby enabling the supply of the processing liquid flowing in the piping 132 toward the nozzle 136 to be stopped.

The controlling portion 102 can control the moving mechanism 138 of the processing liquid supply portion 130 to move the nozzle 136. Specifically, the controlling portion 102 can move the nozzle 136 above the upper surface Wa of the substrate W by controlling the moving mechanism 138 of the processing liquid supply portion 130. In addition, the controlling portion 102 can move the nozzle 136 to a retracted position away from above the upper surface Wa of the substrate W by controlling the moving mechanism 138 of the processing liquid supply portion 130.

The controlling portion 102 controls the near-infrared light source 140 and the near-infrared imaging portion 150 to capture an image of a region including the tip 136a of the nozzle 136 and generate a captured image. The controlling portion 102 controls the near-infrared light source 140 to irradiate a region including the tip 136a of the nozzle 136 with near-infrared rays. In addition, the controlling portion 102 controls the near-infrared imaging portion 150 to capture an image of a region including the tip 136a of the nozzle 136 to generate a captured image.

For example, the controlling portion 102 controls the near-infrared light source 140 and the near-infrared imaging portion 150 to emit near-infrared rays from the near-infrared light source 140 toward a region including the tip 136a of the nozzle 136, receive near-infrared rays transmitted through or reflected by each member in the near-infrared imaging portion 150, and measure a luminance value or brightness. It is noted that, the controlling portion 102 may control the near-infrared light source 140 and the near-infrared imaging portion 150 to move the near-infrared light source 140 and the near-infrared imaging portion 150 with respect to the nozzle 136.

The controlling portion 102 specifies an outer edge of the processing liquid in the captured image. For example, the controlling portion 102 specifies the outer edge of the processing liquid in the captured image based on the luminance value or brightness in the captured image. In one example, the controlling portion 102 specifies the outer edge of the processing liquid in the captured image based on the luminance value or brightness in the captured image and the luminance value or brightness of the reference processing liquid stored in the memory portion 104. Alternatively, the controlling portion 102 specifies the outer edge of the processing liquid in the captured image based on the captured image and the reference image.

In addition, the controlling portion 102 specifies the type of the processing liquid in the captured image based on the luminance value or brightness in the captured image. The type of the processing liquid in the captured image is specified based on the luminance value or brightness in the captured image and the luminance value or brightness of the reference processing liquid stored in the memory portion 104. Alternatively, the controlling portion 102 specifies the type of the processing liquid in the captured image based on the captured image and the reference image.

The controlling portion 102 controls the liquid return portion 160 to return the processing liquid in the nozzle 136 to the upstream side (pipe 132 side). That is, the controlling portion 102 controls the liquid return portion 160 to execute suck back. Specifically, the controlling portion 102 controls the liquid return portion 160 to return the processing liquid in the nozzle 136 to the upstream side (pipe 132 side) in a state where the valve 134 is controlled to stop the supply of the processing liquid to the nozzle 136.

In the present preferred embodiment, the controlling portion 102 causes the near-infrared imaging portion 150 to capture an image of a region including the tip 136a of the nozzle 136 while the processing liquid is moving upstream in the nozzle 136. In other words, the controlling portion 102 causes the near-infrared imaging portion 150 to capture an image of the processing liquid moving upstream in the nozzle 136.

The controlling portion 102 may control the cup 180 to move the cup 180 with respect to the substrate W. Specifically, the controlling portion 102 raises the cup 180 vertically upward to the side of the substrate W over a period in which the processing liquid supply portion 130 supplies the processing liquid to the substrate W. In addition, when the period during which the processing liquid supply portion 130 supplies the processing liquid to the substrate W ends, the controlling portion 102 lowers the cup 180 vertically downward from the side of the substrate W.

The substrate processing apparatus 100 of the present preferred embodiment is suitably used for forming a semiconductor device. For example, the substrate processing apparatus 100 is suitably used for processing the substrate W used as a semiconductor device having a laminated structure. The semiconductor device is a memory (storage) having a so-called 3D structure. As an example, the substrate W is suitably used as a NAND type flash memory.

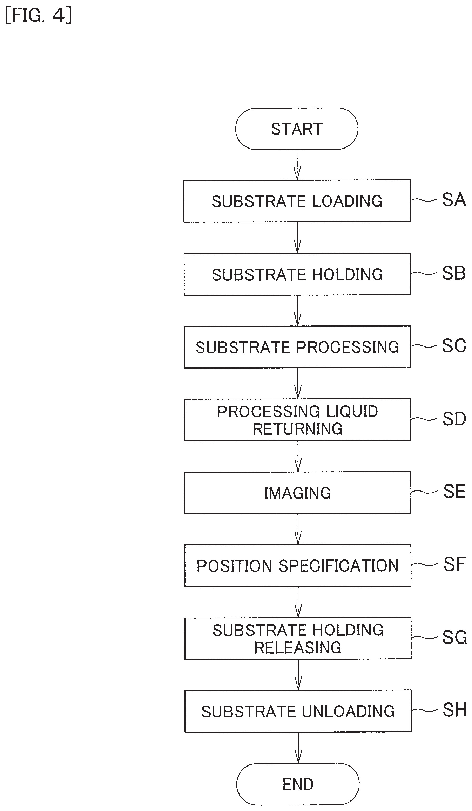

Next, a substrate processing method of the present preferred embodiment will be described with reference to FIGS. 1 to 4. FIG. 4 is a flowchart of the substrate processing method according to the present preferred embodiment. It is noted that, step SC is an example of the "rotating step" and the "supplying step" of the present invention. Step SD is an example of the "returning step" of the present invention. Step SE is an example of the "irradiating step" and the "captured image generating step" of the present invention. Step SF is an example of the "specifying step" of the present invention.

As illustrated in FIG. 4, in step SA, the substrate W is loaded into the substrate processing apparatus 100. Specifically, the substrate W is loaded into the chamber 112 of the substrate processing unit 110 through the indexer robot IR and the center robot CR.

In step SB, the substrate holding portion 120 holds the substrate W. Specifically, when the substrate W is loaded into the chamber 112, the substrate W is held by the substrate holding portion 120.

In step SC, the controlling portion 102 processes the substrate W. The substrate W is processed in the substrate processing unit 110. Typically, the substrate holding portion 120 rotates the substrate W while holding the substrate W, and the processing liquid supply portion 130 supplies the processing liquid to the substrate W. When a predetermined time has elapsed from the start of the supply of the processing liquid to the substrate W, the controlling portion 102 stops the supply of the processing liquid to the substrate W.

In step SD, the controlling portion 102 controls the liquid return portion 160 to return the processing liquid in the nozzle 136 to the upstream side (pipe 132 side). As a result, it is possible to prevent the processing liquid from dropping from the nozzle 136 onto the substrate W.

In step SE, the controlling portion 102 controls the near-infrared imaging portion 150 to generate an image obtained by capturing an image of a region including the tip 136a of the nozzle 136. In the present preferred embodiment, the controlling portion 102 causes the near-infrared imaging portion 150 to capture an image of a region including the tip 136a of the nozzle 136 while the processing liquid in the nozzle 136 moves to the upstream side. In other words, the controlling portion 102 causes the near-infrared imaging portion 150 to capture an image of the processing liquid moving upstream in the nozzle 136. Specifically, the controlling portion 102 controls the near-infrared light source 140 to emit near-infrared rays. The region including the tip 136a of the nozzle 136 is irradiated with near-infrared rays emitted from the near-infrared light source 140. In addition, the controlling portion 102 controls the near-infrared imaging portion 150 to capture an image of at least a part of the region irradiated with near-infrared rays. Specifically, the controlling portion 102 captures an image of a region including the tip 136a of the nozzle 136. By capturing an image of a region including the tip 136a of the nozzle 136 irradiated with near-infrared rays from the near-infrared imaging portion 150, the processing liquid can be captured with high accuracy even if the processing liquid in the nozzle 136 is substantially transparent.

In step SF, the controlling portion 102 specifies the position of the outer edge of the processing liquid in the nozzle 136 based on the captured image.

In step SG, the controlling portion 102 stops the rotation of the substrate W by the substrate holding portion 120 and releases the holding of the substrate W by the substrate holding portion 120. It is noted that, the rotation of the substrate W by the substrate holding portion 120 may be stopped in step SD, step SE, or step SF.

In step SH, the substrate W is unloaded from the substrate processing apparatus 100. Specifically, the substrate W is unloaded from the chamber 112 of the substrate processing unit 110 through the center robot CR and the indexer robot IR.

According to the present preferred embodiment, the controlling portion 102 controls the near-infrared imaging portion 150 to capture an image of a region including the tip 136a of the nozzle 136. In other words, the near-infrared imaging portion 150 captures an image of the processing liquid irradiated with near-infrared rays from the near-infrared light source 140. Since the processing liquid absorbs the near-infrared rays relatively strongly, the outer edge of the processing liquid can be specified with high accuracy.

In addition, the controlling portion 102 causes the near-infrared imaging portion 150 to capture an image of the processing liquid moving upstream in the nozzle 136. Therefore, the processing liquid in the nozzle 136 during the suck back can be specified with high accuracy.

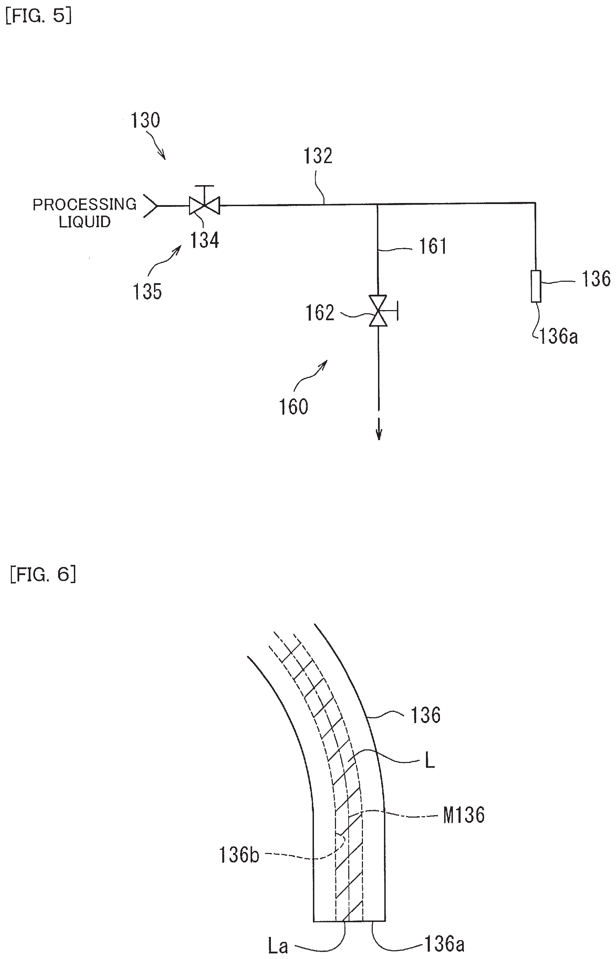

Next, the liquid return portion 160 of the substrate processing apparatus 100 according to the present preferred embodiment will be further described with reference to FIG. 5. FIG. 5 is a schematic view illustrating a configuration around the liquid return portion 160 of the substrate processing apparatus 100 according to the present preferred embodiment.

As illustrated in FIG. 5, the liquid return portion 160 includes a pipe 161 and a valve 162. The pipe 161 is connected to the pipe 132. In the present preferred embodiment, the pipe 161 is connected to a portion of the pipe 132 between the valve 134 and the nozzle 136. In other words, the pipe 161 is connected to the pipe 132 on the upstream side of the valve 134 and on the downstream side of the nozzle 136. The processing liquid on the downstream side (nozzle 136 side) of the connection portion of the pipe 132 to which the pipe 161 is connected flows through the pipe 161. It is noted that, in the present preferred embodiment, an end (lower end) of the pipe 161 that is not connected to the pipe 132 is located at a position lower than the tip 136a of the nozzle 136.

The valve 162 opens and closes a flow path in the pipe 161. The nozzle 136 is connected to the pipe 161. The valve 162 is not particularly limited, but is, for example, an air valve. The valve 162 has, for example, a needle valve capable of changing a flow rate and/or a speed controller capable of changing an opening/closing speed.

The controlling portion 102 controls the valve 162 to open and close the flow path in the pipe 161. Specifically, the controlling portion 102 closes the flow path in the pipe 161 by the valve 162 while the supply portion 135 is supplying the processing liquid to the nozzle 136. On the other hand, the controlling portion 102 controls the valve 162 to open the flow path in the pipe 161 for a predetermined time after stopping the supply of the processing liquid to the nozzle 136 by the supply portion 135. In this case, when the controlling portion 102 changes the valve 162 from the closed state to the open state, a suck back occurs according to the principle of siphon. That is, the processing liquid in the nozzle 136 moves to the upstream side (pipe 132 side). On the other hand, when the controlling portion 102 changes the valve 162 from the open state to the closed state, the suck back is stopped. That is, the movement of the processing liquid in the nozzle 136 is stopped.

In the present preferred embodiment, the controlling portion 102 specifies the position of the end edge (lower surface) of the processing liquid in the nozzle 136 on the downstream side based on the captured image. In addition, the controlling portion 102 calculates the speed at which the processing liquid moves to the upstream side in the nozzle 136 based on the specified position of the end edge of the processing liquid on the downstream side.

For example, the controlling portion 102 causes the near-infrared imaging portion 150 to capture an image of the processing liquid moving to the upstream side in the nozzle 136 when a first predetermined time has elapsed since the liquid return portion 160 started the returning of the processing liquid in the nozzle 136 to the upstream side. Then, the controlling portion 102 calculates the speed at which the processing liquid moves to the upstream side in the nozzle 136 based on the first predetermined time (time from the start of returning of the processing liquid to the upstream side to the imaging of the processing liquid) and the position of the end edge of the processing liquid on the downstream side in the captured image. It is noted that, in the following description, the speed at which the processing liquid moves to the upstream side in the nozzle 136 may be referred to as the speed of the processing liquid.

Alternatively, for example, the controlling portion 102 causes the near-infrared imaging portion 150 to capture an image of the processing liquid moving to the upstream side in the nozzle 136 a plurality of times at second predetermined time intervals. Then, the controlling portion 102 calculates the speed of the processing liquid based on the position of the end edge of the processing liquid on the downstream side in the plurality of captured images and the second predetermined time.

The controlling portion 102 determines whether the calculated speed of the processing liquid is within a predetermined speed range. For example, when determining that the calculated speed of the processing liquid is not within the predetermined speed range, the controlling portion 102 executes a predetermined process. The predetermined process will be described later. It is noted that, the predetermined speed range is stored in the memory portion 104.

Next, a method for calculating the speed of the processing liquid L by the substrate processing apparatus 100 of the present preferred embodiment will be described with reference to FIGS. 6 to 10. FIGS. 6 to 10 and FIG. 11 to be described later are schematic views illustrating the tip portion of the nozzle 136 during the suck back. It is noted that, FIGS. 6 to 10 and FIG. 11 to be described later correspond to the captured image captured by the near-infrared imaging portion 150. In addition, in FIGS. 6 to 10 and FIG. 11 to be described later, the processing liquid L is hatched for easy understanding.

First, a method of specifying a center line M136 of a liquid flow path 136b of the nozzle 136 will be described with reference to FIG. 6.

As illustrated in FIG. 6, the nozzle 136 has a liquid flow path 136b through which the processing liquid L passes. The controlling portion 102 specifies the center line M136 of the liquid flow path 136b based on the captured image. For example, the controlling portion 102 specifies the center line M136 of the liquid flow path 136b based on the position of the outer peripheral edge of the nozzle 136 and/or the position of the inner peripheral edge of the liquid flow path 136b in the captured image. Alternatively, the controlling portion 102 may specify the center line M136 of the liquid flow path 136b based on the position of the outer peripheral edge of the processing liquid L illustrated in FIG. 6.

Next, a method of calculating the speed of the processing liquid L will be described with reference to FIGS. 6 to 10. First, referring to FIGS. 6 to 8, a method will be described in which an image of the processing liquid L in the nozzle 136 is captured after a first predetermined time has elapsed since the processing liquid L in the nozzle 136 starts to be returned to the upstream side, and the speed of the processing liquid L is calculated based on the obtained captured image.

As illustrated in FIG. 6, when the controlling portion 102 stops the supply of the processing liquid L to the nozzle 136 by the supply portion 135, the end edge (lower surface) La of the processing liquid L on the downstream side is substantially flush with the tip 136a of the nozzle 136. From this state, the controlling portion 102 opens the valve 162. As a result, the processing liquid L in the nozzle 136 is returned to the upstream side. That is, the returning (suck back) of the processing liquid L is started.

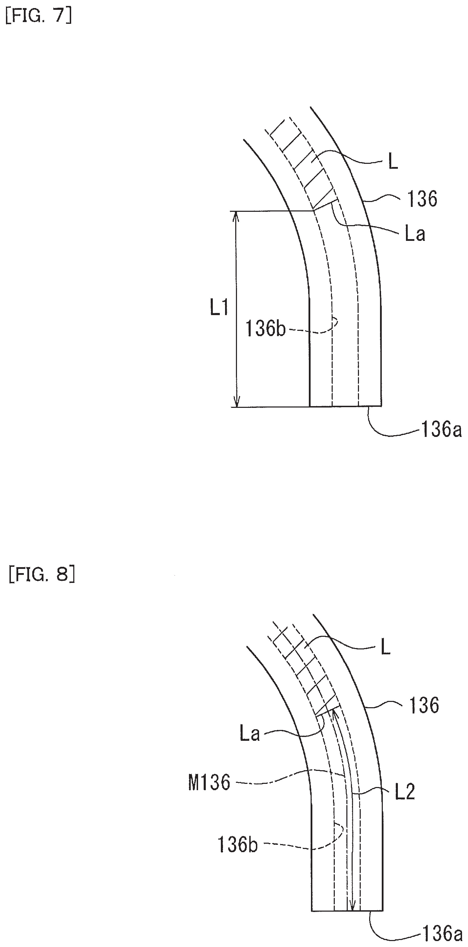

Then, the controlling portion 102 causes the near-infrared imaging portion 150 to capture an image of a region including the tip 136a of the nozzle 136 when a first predetermined time has elapsed since the processing liquid L in the nozzle 136 starts to be returned to the upstream side by the liquid return portion 160. Thus, for example, a captured image as illustrated in FIG. 7 is generated by the near-infrared imaging portion 150. Thereafter, the controlling portion 102 specifies the position of an end edge La on the downstream side of the processing liquid L from the tip 136a of the nozzle 136 based on the captured image. Then, as illustrated in FIG. 7, the controlling portion 102 calculates a distance L1 from the tip 136a of the nozzle 136 to the specified position of the end edge La. At this time, the controlling portion 102 calculates a distance L1 in the vertical direction from the tip 136a of the nozzle 136 to the specified position of the end edge La. Alternatively, the controlling portion 102 calculates a distance L1 from the tip 136a of the nozzle 136 to the specified position of the end edge La in the direction orthogonal to the tip 136a. Thereafter, the controlling portion 102 calculates the speed of the processing liquid L based on the calculated distance L1 and the first predetermined time.

Alternatively, as illustrated in FIG. 8, the controlling portion 102 calculates a length L2 by which the end edge (lower surface) La of the processing liquid L has moved along the center line M136 of the liquid flow path 136b based on the captured image. Then, the controlling portion 102 calculates the speed of the processing liquid L based on the length L2 and the first predetermined time.

Next, referring to FIGS. 6, 9, and 10, a method will be described in which the image of the processing liquid L moving to the upstream side in the nozzle 136 is captured a plurality of times at second predetermined time intervals, and the speed of the processing liquid L is calculated based on the obtained captured image.

As illustrated in FIG. 6, when the controlling portion 102 stops the supply of the processing liquid L to the nozzle 136 by the supply portion 135, the end edge (lower surface) La of the processing liquid L on the downstream side is substantially flush with the tip 136a of the nozzle 136. From this state, the controlling portion 102 opens the valve 162. As a result, the processing liquid L in the nozzle 136 is returned to the upstream side. That is, the returning (suck back) of the processing liquid L is started.

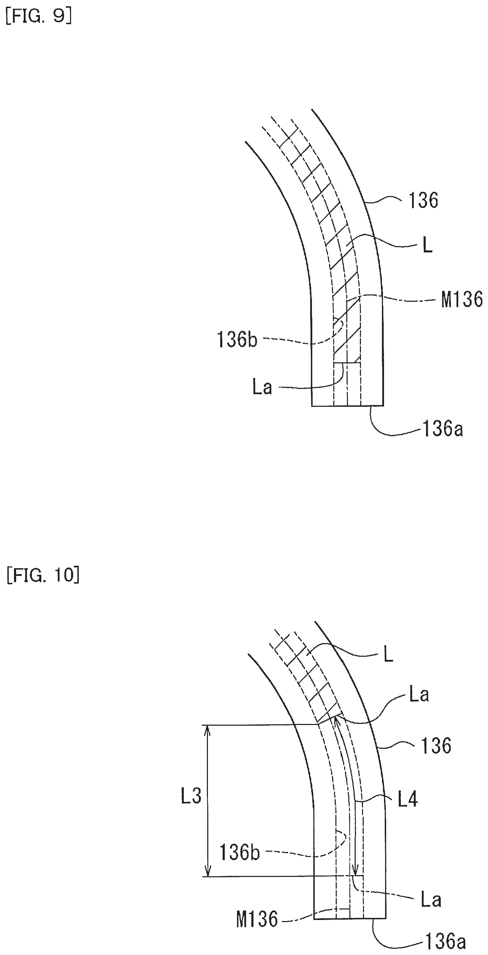

Then, the controlling portion 102 captures an image of the processing liquid L moving to the upstream side in the nozzle 136 a plurality of times (here, two times) at second predetermined time intervals. Specifically, the second predetermined time may be the reciprocal of the frame rate or an integer multiple of the reciprocal of the frame rate. The controlling portion 102 causes the near-infrared imaging portion 150 to capture an image of a region including the tip 136a of the nozzle 136 at a second predetermined time interval. Thus, for example, captured images as illustrated in FIGS. 9 and 10 are generated by the near-infrared imaging portion 150. Thereafter, the controlling portion 102 specifies the position of the end edge La on the downstream side of the processing liquid L in the nozzle 136 based on the captured image. The position of the end edge La is specified for each captured image. Then, the controlling portion 102 calculates the speed of the processing liquid L based on the position of the end edge La on the downstream side of the processing liquid L in the plurality of captured images and the second predetermined time.

Specifically, as illustrated in FIGS. 9 and 10, the distance between the positions of the end edge La in the two captured images is calculated. Then, as illustrated in FIG. 10, the controlling portion 102 calculates a distance L3 in the vertical direction between the end edges La in the two captured images. Alternatively, the controlling portion 102 calculates a distance L3 in a direction orthogonal to the tip 136a between the end edges La in the two captured images. Then, the controlling portion 102 calculates the speed of the processing liquid L based on the calculated distance L3 and the second predetermined time.

Alternatively, the controlling portion 102 calculates a length L4 by which the end edge La of the processing liquid L has moved along the center line M136 of the liquid flow path 136b based on the two captured images. Then, the controlling portion 102 calculates the speed of the processing liquid L based on the length L4 and the second predetermined time.

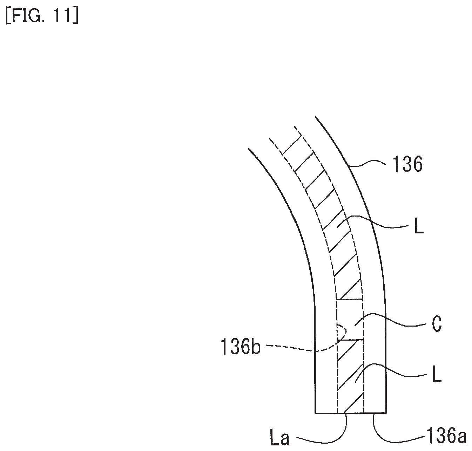

Next, an example in which the processing liquid L is separated in the nozzle 136 during the suck back will be described with reference to FIG. 11. FIG. 11 is a schematic view illustrating a state in which the processing liquid L is separated in the nozzle 136 during the suck back.

As illustrated in FIG. 11, when the processing liquid L is sucked back, the processing liquid L may be separated in the nozzle 136. In this case, a cavity C is formed between the processing liquid L and the processing liquid L. Since the cavity C hardly absorbs near-infrared rays, the luminance or brightness of the captured image greatly changes at the interface between the cavity C and the processing liquid L. Therefore, the controlling portion 102 can determine the presence or absence of separation of the processing liquid L based on the captured image. The separation of the processing liquid L occurs when the returning speed of the processing liquid L is high. Therefore, when it is determined that the processing liquid L has been separated, the controlling portion 102 executes a predetermined process. The predetermined process will be described later.

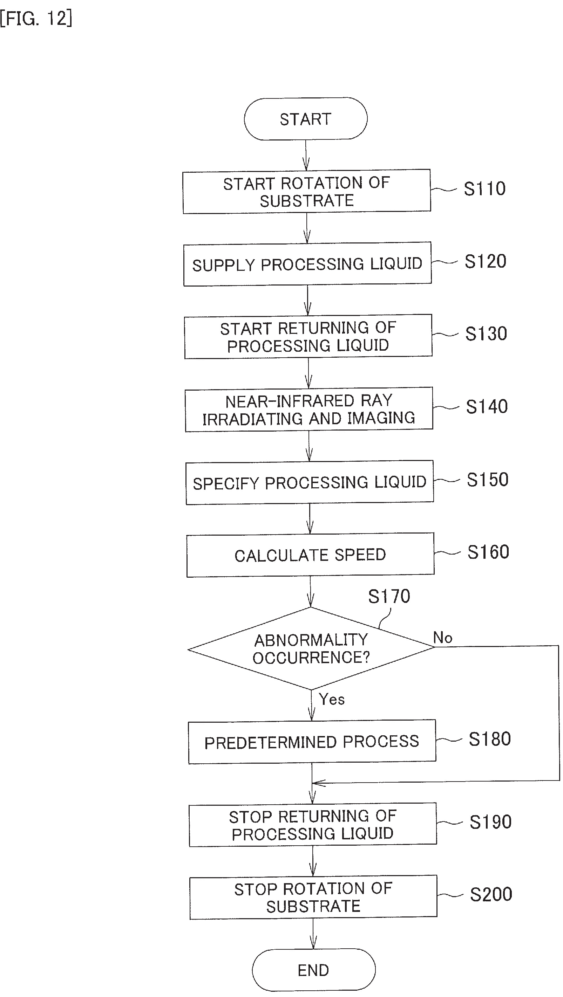

Next, a substrate processing step in the substrate processing method of the present preferred embodiment will be described with reference to FIGS. 1 to 12. FIG. 12 is a flowchart of a substrate processing step in the substrate processing method of the present preferred embodiment. It is noted that, step S110 is an example of the "rotating step" of the present invention. Specifically, the process from step S110 to step S200 in which the rotation of the substrate W is stopped is an example of the "rotating step" of the present invention. Step S120 is an example of the "supplying step" of the present invention. Step S130 is an example of the "returning step" of the present invention. Specifically, the process from step S130 to step S190 in which the returning of the processing liquid L is stopped is an example of the "returning step" of the present invention. Step S140 is an example of the "irradiating step" and the "captured image generating step" of the present invention. Step S150 is an example of the "specifying step" of the present invention. Step S160 is an example of the "calculating step" of the present invention. Step S170 is an example of the "determining step" of the present invention. Step S180 is an example of the "step of changing at least one of a timing of starting returning and a timing of stopping returning" of the present invention.

As illustrated in FIG. 12, in step S110, the substrate W rotates in a held state. Specifically, the substrate holding portion 120 rotates the substrate W while holding the substrate W. For example, the rotational speed of the substrate W is 10 rpm to 1500 rpm.

Next, in step S120, the processing liquid L is supplied to the substrate W. Specifically, the controlling portion 102 controls the processing liquid supply portion 130 to supply the processing liquid L to the substrate W. When a predetermined time has elapsed from the start of the supply of the processing liquid L to the substrate W, the controlling portion 102 controls the processing liquid supply portion 130 to stop the supply of the processing liquid L to the substrate W.

Next, in step S130, the controlling portion 102 starts returning of the processing liquid L. Specifically, the controlling portion 102 brings the valve 162 of the liquid return portion 160 into the open state to return the processing liquid L in the nozzle 136 to the upstream side. As a result, the processing liquid L in the nozzle 136 starts to move toward the upstream side.

Next, in step S140, the near-infrared light source 140 irradiates a region including the tip 136a of the nozzle 136 with near-infrared rays, and the near-infrared imaging portion 150 captures an image of a region including the tip 136a of the nozzle 136 irradiated with near-infrared rays. At this time, the near-infrared imaging portion 150 captures an image of the processing liquid L moving to the upstream side in the nozzle 136. The near-infrared light source 140 irradiates a region including the tip 136a with near-infrared rays, and the near-infrared imaging portion 150 captures an image of a region including the tip 136a irradiated with near-infrared rays to generate a captured image. The controlling portion 102 controls the near-infrared light source 140 and the near-infrared imaging portion 150 such that the near-infrared light source 140 emits near-infrared rays toward a region including the tip 136a and the near-infrared imaging portion 150 captures an image of a region including the tip 136a. It is noted that, the timing at which the near-infrared light source 140 starts emitting near-infrared rays may be the same as or different from the timing at which the near-infrared imaging portion 150 starts imaging. In addition, the timing at which the near-infrared light source 140 starts emitting near-infrared rays may be earlier or later than the timing at which the near-infrared imaging portion 150 starts imaging. In addition, the timing at which the near-infrared light source 140 starts emitting near-infrared rays may be the same as or different from the timing at which the processing liquid L is returned in step S130. In addition, the timing at which the near-infrared light source 140 starts emitting near-infrared rays may be earlier or later than the timing at which the processing liquid L is returned in step S130.

Next, in step S150, the position of the outer edge of the processing liquid L in the captured image is specified based on the captured image generated by the near-infrared imaging portion 150. Specifically, for example, the controlling portion 102 specifies the position of the end edge La on the downstream side of the processing liquid L based on the captured image. In addition, for example, the controlling portion 102 specifies the boundary position between the processing liquid L and the cavity C based on the captured image. In addition, the controlling portion 102 may further specify the type of the processing liquid L in the captured image based on the captured image. It is noted that, the controlling portion 102 may specify the position of the center line M136 of the liquid flow path 136b based on the captured image. However, the specifying of the center line M136 may be performed before step S150.

For example, the controlling portion 102 specifies the position of the outer edge of the processing liquid L in the captured image based on the luminance value or brightness in the captured image. For example, the controlling portion 102 specifies the position of the outer edge of the processing liquid L in the captured image based on the luminance value or brightness in the captured image and the luminance value or brightness of the reference processing liquid stored in the memory portion 104. Alternatively, the controlling portion 102 specifies the position of the outer edge of the processing liquid L in the captured image based on the captured image and the reference image. Alternatively, for example, the controlling portion 102 may determine a region having a luminance value or brightness within a predetermined range in the captured image as the processing liquid L, and may determine an outer edge of the region having a luminance value or brightness within a predetermined range as the outer edge of the processing liquid L.

In addition, the controlling portion 102 specifies the type of the processing liquid L in the captured image based on the luminance value or brightness in the captured image. The type of the processing liquid L in the captured image is specified based on the luminance value or brightness in the captured image and the luminance value or brightness of the reference processing liquid stored in the memory portion 104. Alternatively, the controlling portion 102 specifies the type of the processing liquid L in the captured image based on the captured image and the reference image.

Next, in step S160, the speed at which the processing liquid L moves to the upstream side in the nozzle 136 is calculated based on the specified position of the end edge La on the downstream side of the processing liquid L. Specifically, the controlling portion 102 calculates the speed of the processing liquid L by the method described with reference to FIGS. 6 to 10.

Next, in step S170, it is determined whether an abnormality has occurred. The controlling portion 102 determines the presence or absence of the occurrence of abnormality based on the position of the outer edge of the processing liquid L.

For example, the controlling portion 102 determines the presence or absence of the occurrence of abnormality based on the speed of the processing liquid L calculated in step S160. In this case, the controlling portion 102 determines whether or not the speed of the processing liquid L is within a predetermined range. When the speed of the processing liquid L is within a predetermined range, the controlling portion 102 determines that no abnormality has occurred. On the other hand, when the speed of the processing liquid L is out of the predetermined range, the controlling portion 102 determines that an abnormality has occurred. For example, when the speed of the processing liquid L is higher than the predetermined range, the processing liquid L is returned to the pipe 132 side more than necessary. On the other hand, when the speed of the processing liquid L is lower than the predetermined range, the processing liquid L is not sufficiently returned to the pipe 132 side.

Alternatively, for example, the controlling portion 102 determines the presence or absence of separation of the processing liquid L based on the position of the outer edge of the processing liquid L. It is noted that, when the controlling portion 102 does not calculate the speed of the processing liquid L and determines the presence or absence of separation of the processing liquid L, step S160 may be omitted. For example, the controlling portion 102 determines whether or not the cavity C is formed based on the position of the outer edge of the processing liquid L. When the cavity C is not formed, the controlling portion 102 determines that no abnormality has occurred. On the other hand, when the cavity C is formed, the controlling portion 102 determines that an abnormality has occurred.

In addition, the controlling portion 102 may compare the type of the processing liquid L calculated based on the captured image with the type of the processing liquid L in the recipe data to determine whether or not the type of the processing liquid L being used is correct.

When the controlling portion 102 determines in step S170 that no abnormality has occurred, the processing proceeds to step S190.

On the other hand, when the controlling portion 102 determines in step S170 that an abnormality has occurred, the processing proceeds to step S180.

Next, in step S180, the controlling portion 102 executes a predetermined process. Hereinafter, the predetermined process will be described.

Specifically, when the speed of the processing liquid L is higher than the predetermined range, the controlling portion 102 changes at least one of the timing of starting returning of the processing liquid L to the upstream side (the timing of opening the valve 162) and the timing of stopping the returning of the processing liquid L to the upstream side (the timing of closing the valve 162) based on the specified position of the outer edge of the processing liquid L.

For example, when the speed of the processing liquid L is higher than the predetermined range, the controlling portion 102 may rewrite the recipe so that the timing of starting returning of the processing liquid L to the upstream side is delayed. For example, when the speed of the processing liquid L is higher than the predetermined range, the controlling portion 102 may rewrite the recipe so that the timing of stopping the returning of the processing liquid L to the upstream side is advanced.

In addition, when the speed of the processing liquid L is higher than the predetermined range, for example, the controlling portion 102 may control the speed controller and/or the needle valve of the valve 162 to slow the opening/closing speed of the valve 162 and/or reduce the flow rate of the processing liquid L flowing through the pipe 161. In addition, the controlling portion 102 may notify the user of notification information indicating that the speed of the processing liquid L is higher than the predetermined range. In this case, the user may manually adjust the speed controller and/or the needle valve of the valve 162 so that the opening/closing speed of the valve 162 is slow and/or the flow rate of the processing liquid L flowing through the pipe 161 is low. A method for notifying the user of the notification information is not particularly limited, and for example, the notification information may be displayed on a display panel included in the substrate processing apparatus 100, an error lamp may be turned on, or notification may be performed by voice.

In addition, for example, when the speed of the processing liquid L is lower than the predetermined range, the controlling portion 102 may rewrite the recipe so that the timing of starting returning of the processing liquid L to the upstream side is advanced. In addition, for example, when the speed of the processing liquid L is lower than the predetermined range, the controlling portion 102 may rewrite the recipe so that the timing of stopping the returning of the processing liquid L to the upstream side is delayed.

In addition, when the speed of the processing liquid L is lower than the predetermined range, for example, the controlling portion 102 may control the speed controller and/or the needle valve of the valve 162 to increase the opening/closing speed of the valve 162 and/or increase the flow rate of the processing liquid L flowing through the pipe 161. In addition, the controlling portion 102 may notify the user of notification information indicating that the speed of the processing liquid L is lower than the predetermined range. In this case, the user may manually adjust the speed controller and/or the needle valve of the valve 162 so that the opening/closing speed of the valve 162 is increased and/or the flow rate of the processing liquid L flowing through the pipe 161 is increased.

In addition, for example, when the separation of the processing liquid L occurs, for example, the controlling portion 102 may control the speed controller and/or the needle valve of the valve 162 to slow the opening/closing speed of the valve 162 and/or reduce the flow rate of the processing liquid L flowing through the pipe 161. In addition, the controlling portion 102 may notify the user of notification information indicating that the speed of the processing liquid L is higher than the predetermined range. In this case, the user may manually adjust the speed controller and/or the needle valve of the valve 162 so that the opening/closing speed of the valve 162 is slow and/or the flow rate of the processing liquid L flowing through the pipe 161 is low.

In addition, when the type of the processing liquid L being used (the specified processing liquid L) is incorrect, for example, the controlling portion 102 may notify the user of notification information indicating that the processing liquid L being used is incorrect.

Next, in step S190, the controlling portion 102 stops the returning of the processing liquid L. Specifically, when a predetermined time has elapsed since the start of the returning of the processing liquid L in step S130, the controlling portion 102 closes the valve 162 of the liquid return portion 160 and stops the returning of the processing liquid L. It is noted that, the timing of stopping the returning of the processing liquid L may not be after the execution of the predetermined process in step S180. For example, the timing of stopping the returning of the processing liquid L may be between step S140 and step S180.

Next, in step S200, the rotation of the substrate W is stopped. Specifically, the controlling portion 102 controls the substrate holding portion 120 such that the substrate holding portion 120 stops the rotation of the substrate W.

In the present preferred embodiment, as described above, the controlling portion 102 specifies the position of the end edge La on the downstream side of the processing liquid L in the nozzle 136 based on the captured image. Therefore, the calculation of the speed of the processing liquid L and/or the determination of the presence or absence of separation of the processing liquid L can be easily performed.

In addition, as described above, the controlling portion 102 calculates the speed of the processing liquid L based on the position of the end edge La of the processing liquid L. Therefore, the speed of the processing liquid L during the suck back can be easily calculated.

In addition, as described above, when the first predetermined time has elapsed since the controlling portion 102 started returning of the processing liquid L to the upstream side, the near-infrared imaging portion 150 captures an image of the processing liquid L moving to the upstream side in the nozzle 136, and the speed of the processing liquid L is calculated based on the position of the end edge La of the processing liquid L and the first predetermined time. Therefore, the speed of the processing liquid L during the suck back can be calculated more easily.

In addition, as described above, the controlling portion 102 captures an image of the processing liquid L moving to the upstream side in the nozzle 136 by the near-infrared imaging portion 150 a plurality of times at the second predetermined time interval, and calculates the speed of the processing liquid L based on the position of the end edge La of the processing liquid L in the plurality of captured images and the second predetermined time. Also in this case, the speed of the processing liquid L during the suck back can be calculated more easily.

In addition, as described above, the controlling portion 102 calculates the speed of the processing liquid L based on the distance L1 from the tip 136a of the nozzle 136 to the end edge La of the processing liquid L. Therefore, the speed of the processing liquid L can be calculated more easily. It is noted that, the controlling portion 102 may calculate the speed of the processing liquid L based on the distance L3. Also in this case, the speed of the processing liquid L can be calculated more easily.

Alternatively, as described above, the controlling portion 102 calculates the speed of the processing liquid L based on the length L2 or the length L4 by which the end edge La of the processing liquid L has moved along the center line M136 of the liquid flow path 136b and the first predetermined time or the second predetermined time. Therefore, the speed of the processing liquid L can be calculated more accurately.

As described above, when determining that an abnormality has occurred, the controlling portion 102 changes at least one of the timing of starting returning of the processing liquid L to the upstream side and the timing of stopping the returning of the processing liquid L to the upstream side based on the position of the outer edge of the processing liquid L. Therefore, the speed of the processing liquid L can be easily set within a predetermined range.

In addition, as described above, the controlling portion 102 specifies the type of the processing liquid L based on the captured image. Therefore, by comparing the type of the processing liquid L specified based on the captured image with the type of the processing liquid L in the recipe data, it is possible to confirm whether or not the type of the processing liquid L being used is correct.

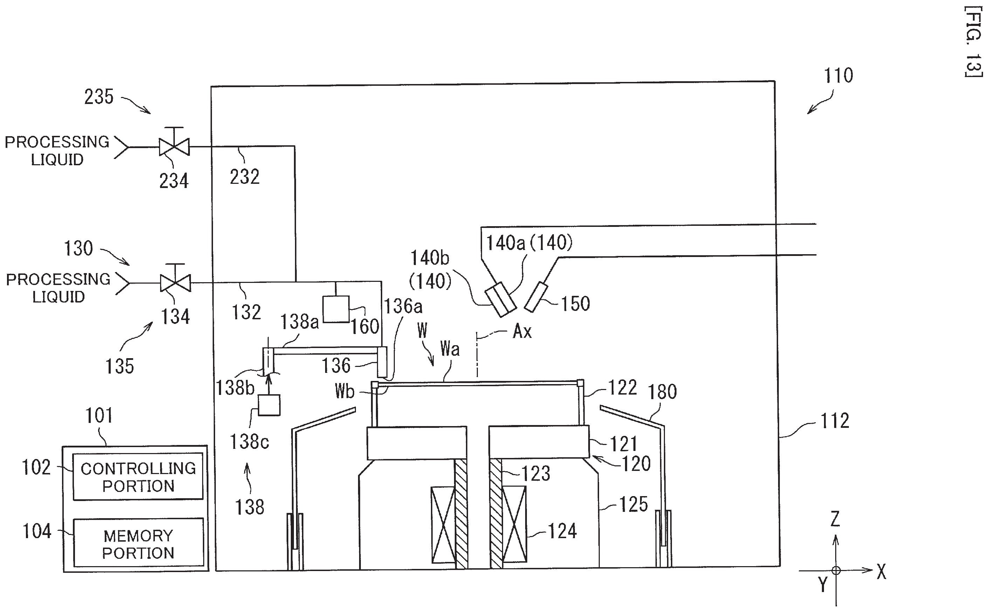

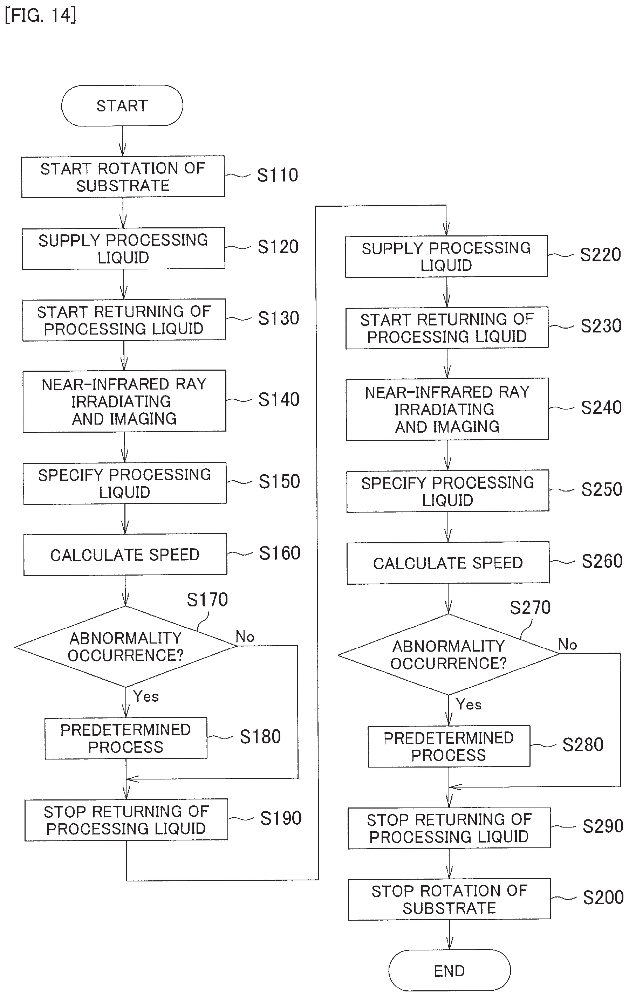

Next, an example in which the near-infrared light source 140 includes a plurality of near-infrared light sources 140a and a plurality of near-infrared light sources 140b will be described with reference to FIGS. 13 and 14. FIG. 13 is a schematic view of the substrate processing unit 110 in the substrate processing apparatus 100 including a plurality of near-infrared light sources 140a and near-infrared light sources 140b.

As illustrated in FIG. 13, the near-infrared light source 140 includes a plurality of (here, two) near-infrared light sources 140a and near-infrared light sources 140b. The near-infrared light source 140a and the near-infrared light source 140b emit near-infrared rays having peak wavelengths different from each other.

The processing liquid supply portion 130 supplies a plurality of types (here, two kinds) of processing liquids L to the substrate W.

The processing liquid supply portion 130 further includes a pipe 232 and a valve 234. The processing liquid L from the supply source flows through the pipe 232. The valve 234 opens and closes a flow path in the pipe 232. The pipe 232 is connected to the pipe 132. In the present preferred embodiment, the pipe 232 is connected to a position on the upstream side of the liquid return portion 160 in the pipe 132. In the present preferred embodiment, the pipe 232 and the valve 234 constitute a supply portion 235 that supplies the processing liquid L to the nozzle 136. It is noted that, the supply portion 235 may include a pump (not illustrated) that feeds the processing liquid L from a supply source. Other configurations of the supply portion 235 (the pipe 232 and the valve 234) are similar to those of the supply portion 135 (the pipe 132 and the valve 134).

The controlling portion 102 acquires type information indicating the type of the processing liquid L. For example, the controlling portion 102 acquires the type of the processing liquid L supplied by the supply portion 135 and the type of the processing liquid L supplied by the supply portion 235 from the recipe data. In addition, for example, the recipe data may include information indicating the type of the near-infrared light source 140 corresponding to the type of the processing liquid L. In addition, for example, the controlling portion 102 may acquire the type of the processing liquid L supplied by the supply portion 135 and the type of the processing liquid L supplied by the supply portion 235 from the input information input by the user.

The controlling portion 102 changes the near-infrared light source 140 that irradiates a region including the tip 136a of the nozzle 136 according to the acquired type information. For example, when the processing liquid L is supplied from the supply portion 135, the controlling portion 102 performs irradiation by the near-infrared light source 140a. On the other hand, when the processing liquid L is supplied from the supply portion 235, the controlling portion 102 performs irradiation by the near-infrared light source 140b.

Specifically, for example, it is assumed that the processing liquid L supplied by the supply portion 135 is DIW and the processing liquid L supplied by the supply portion 235 is ethanol. In addition, for example, it is assumed that the near-infrared light source 140a emits near-infrared rays having a peak wavelength of about 1.4 µm, and the near-infrared light source 140b emits near-infrared rays having a peak wavelength of about 1.6 µm or about 1.7 µm. DIW has high absorbance (also referred to as absorbance rate) for light with a wavelength of about 1.4 µm. On the other hand, ethanol has high absorbance for light at wavelengths of about 1.6 µm and about 1.7 µm. Therefore, when the supply portion 135 supplies the processing liquid L (DIW), the contrast of the luminance value or brightness between the region indicating the processing liquid L and the region indicating the portion other than the processing liquid L in the captured image can be increased by performing irradiation by the near-infrared light source 140a. Therefore, the position of the end edge of the processing liquid L can be more accurately specified based on the captured image. In addition, when the supply portion 235 supplies the processing liquid L (ethanol), by performing irradiation by the near-infrared light source 140b, it is possible to increase the contrast of the luminance value or brightness between the region indicating the processing liquid L and the region indicating the portion other than the processing liquid L in the captured image. Therefore, the position of the end edge of the processing liquid L can be more accurately specified based on the captured image.

FIG. 14 is a flowchart of a substrate processing step in an example in which the near-infrared light source 140 includes a plurality of near-infrared light sources 140a and near-infrared light sources 140b. It is noted that, in the substrate processing flow illustrated in FIG. 14, step S110 is an example of the "rotating step" and the "acquiring step" of the present invention. Step S220 is an example of the "supplying step" of the present invention. Step S230 is an example of the "returning step" of the present invention. Specifically, the process from step S230 to step S290 in which the returning of the processing liquid L is stopped is an example of the "returning step" of the present invention. Step S240 is an example of the "irradiating step", "captured image generating step ", and "near-infrared light source changing step" of the present invention. Step S250 is an example of the "specifying step" of the present invention. Step S260 is an example of the "calculating step" of the present invention. Step S270 is an example of the "determining step" of the present invention. Step S280 is an example of the "step of changing at least one of a timing of starting returning and a timing of stopping returning" of the present invention.

As illustrated in FIG. 14, steps S110 to S190 are similar to the flow illustrated in FIG. 12. However, here, the controlling portion 102 acquires the recipe data, for example, in step S110. At this time, the controlling portion 102 acquires type information indicating the type of the processing liquid L. In addition, in step S140, the near-infrared light source 140a emits rays.

Next, in step S220, the processing liquid L is supplied from the supply portion 235 to the substrate W. Specifically, the controlling portion 102 controls the supply portion 235 to supply the processing liquid L to the substrate W. When a predetermined time has elapsed from the start of the supply of the processing liquid L to the substrate W, the controlling portion 102 controls the supply portion 235 to stop the supply of the processing liquid L to the substrate W.

Next, in step S230, the controlling portion 102 starts returning of the processing liquid L. Specifically, the controlling portion 102 brings the valve 162 of the liquid return portion 160 into the open state to return the processing liquid L in the nozzle 136 to the upstream side. As a result, the processing liquid L in the nozzle 136 starts to move toward the upstream side.

Next, in step S240, the controlling portion 102 changes the near-infrared light source 140 that irradiates a region including the tip 136a of the nozzle 136 from the near-infrared light source 140a to the near-infrared light source 140b. As a result, the near-infrared light source 140b irradiates a region including the tip 136a of the nozzle 136 with near-infrared rays, and the near-infrared imaging portion 150 captures an image of a region including the tip 136a of the nozzle 136 irradiated with near-infrared rays. Other control in step S240 is similar to that in step S140.

Subsequent steps S250 to S290 are similar to steps S150 to S190. In addition, step S200 is similar to the flow illustrated in FIG. 12.

However, in step S280, the controlling portion 102 may change at least one of the timing of starting returning of the processing liquid L to the upstream side and the timing of stopping the returning of the processing liquid L to the upstream side based on the type of the processing liquid L specified in step S250. In addition, the controlling portion 102 may control the speed controller and/or the needle valve of the valve 162 based on the type of the processing liquid L specified in step S250.

In the present preferred embodiment, as described above, in the controlling portion 102, the controlling portion 102 acquires the type information indicating the type of the processing liquid L, and changes the near-infrared light source 140 that irradiates a region including the tip 136a of the nozzle 136 based on the acquired type information. Therefore, since the near-infrared rays to be irradiated can be changed according to the absorbance of the processing liquid L, the position of the end edge of the processing liquid L can be accurately specified even when the type of the processing liquid L is changed.

Other control and effects of the substrate processing flow illustrated in FIG. 14 are similar to the control and effects of the substrate processing flow illustrated in FIG. 12.

The embodiments of the present invention have been described above with reference to the drawings. However, the present invention is not limited to the embodiments described above, and can be implemented in various modes within the range not departing from the gist thereof. Also, by appropriately combining the plurality of constituent elements disclosed in the embodiment described above, it is possible to form various inventions. For example, some constituent elements may be deleted from all constituent elements shown in the embodiment. Further, the constituent elements of different embodiments may be appropriately combined. The drawings schematically show the respective constituent elements mainly in order to facilitate understanding, and the thickness, the length, the number, the interval, etc., of each constituent element shown in the drawings may be different from the actual ones for convenience in creating the drawings. Also, the material, the shape, the size, etc., of each constituent element shown in the embodiment described above are not particularly limited but just an example, and can be variously changed within the range substantially not departing from the effects of the present invention.

For example, in the above preferred embodiment, an example in which the image of the processing liquid L is captured only during the suck back has been described, but the present invention is not limited thereto. For example, the image of the processing liquid L may be captured not only during the suck back but also during the supply of the processing liquid L to the substrate W.

In addition, according to the above preferred embodiment, an example of specifying the type of the processing liquid L based on the captured image has been described, but the present invention is not limited thereto. For example, the luminance value or brightness of the processing liquid L in the captured image varies depending on the concentration of the processing liquid L. In addition, the type of the processing liquid L can be acquired from the recipe data. Therefore, the concentration of the processing liquid L may be specified based on the information on the type and concentration of the processing liquid L and the captured image.

In addition, in FIG. 13, an example in which two types of processing liquids L are supplied from the same nozzle 136 to the substrate W has been described, but the present invention is not limited thereto. For example, two types of processing liquids L may be supplied to the substrate W from different nozzles. Also in this case, the near-infrared light source 140 to be irradiated may be changed according to the type of the processing liquid L.

### Industrial Applicability

The present invention is suitably used for a substrate processing apparatus and a substrate processing method.

### Reference Signs List

100: Substrate processing apparatus
102: Controlling portion
120: Substrate holding portion
135: Supply portion
136: Nozzle (processing liquid nozzle)
136a: Tip
136b: Liquid flow path
140, 140a, 140b: Near-infrared light source
150: Near-infrared imaging portion
160: Liquid return portion
235: Supply portion
L: Processing liquid
L1: Distance
L2, L4: Length
La: End edge
M136: Center line
S110: Step (rotating step and acquiring step)
S120, S220: Step (supplying step)
S130, S230: Step (returning step)
S140: Step (irradiating step and captured image generating step)
S150, S250: Step (specifying step)
S160, S260: Step (calculating step)
S170, S270: Step (determining step)
S180, S280: Step (step of changing at least one of timing of starting returning and timing of stopping returning)
S240: Step (irradiating step, captured image generating step, and near-infrared light source changing step)
SC: Step (rotating step and supplying step)
SD: Step (returning step)
SE: Step (irradiating step and captured image generating step)
SF: Step (specifying step)
W: Substrate
Wa: Upper surface

## Claims

1. A substrate processing apparatus comprising:
a substrate holding portion which holds a substrate and rotates the substrate;
a processing liquid nozzle which supplies a processing liquid to an upper surface of the substrate;
a supply portion which supplies the processing liquid to the processing liquid nozzle;
a liquid return portion which returns the processing liquid in the processing liquid nozzle to an upstream side;
a near-infrared light source which irradiates a region including a tip of the processing liquid nozzle with near-infrared rays;
a near-infrared imaging portion which generates a captured image obtained by capturing an image of the processing liquid irradiated with the near-infrared rays from the near-infrared light source; and
a controlling portion which controls the supply portion, the liquid return portion, and the near-infrared imaging portion,
wherein the controlling portion;
stops the supply of the processing liquid by the supply portion and returns the processing liquid in the processing liquid nozzle to the upstream side by the liquid return portion,
captures an image of the processing liquid moving to the upstream side in the processing liquid nozzle by the near-infrared imaging portion, and
specifies a position of an outer edge of the processing liquid in the processing liquid nozzle based on the captured image.

2. The substrate processing apparatus according to claim 1, wherein the controlling portion specifies a position of an end edge of the processing liquid on a downstream side in the processing liquid nozzle based on the captured image.

3. The substrate processing apparatus according to claim 2, wherein the controlling portion calculates a speed at which the processing liquid moves to an upstream side in the processing liquid nozzle based on the specified position of the end edge of the processing liquid on the downstream side.

4. The substrate processing apparatus according to claim 3,
wherein the controlling portion
captures an image of the processing liquid moving to the upstream side in the processing liquid nozzle by the near-infrared imaging portion when a predetermined time has elapsed since the liquid return portion starts returning of the processing liquid in the processing liquid nozzle to the upstream side, and
calculates the speed based on the specified position of the end edge of the processing liquid on the downstream side and the predetermined time.

5. The substrate processing apparatus according to claim 4,
wherein the controlling portion
calculates a distance from a tip of the processing liquid nozzle to the end edge of the processing liquid on the downstream side based on the captured image and
calculates the speed based on the calculated distance and the predetermined time.

6. The substrate processing apparatus according to claim 3,
wherein the controlling portion
captures an image of the processing liquid moving to the upstream side in the processing liquid nozzle a plurality of times at predetermined time intervals by the near-infrared imaging portion and
calculates the speed based on a position of the end edge of the processing liquid on the downstream side in a plurality of the captured images and the predetermined time.

7. The substrate processing apparatus according to any one of claims 4 to 6,
wherein the processing liquid nozzle has a liquid flow path through which the processing liquid passes, and
wherein the controlling portion
specifies a center line of the liquid flow path based on the captured image and
calculates the speed based on a length of movement of the end edge of the processing liquid on the downstream side along the center line of the liquid flow path and the predetermined time.

8. The substrate processing apparatus according to any one of claims 1 to 7,
wherein the controlling portion
determines the presence or absence of occurrence of abnormality based on the specified position of the outer edge of the processing liquid and
changes at least one of a timing of starting returning of the processing liquid to the upstream side and a timing of stopping returning of the processing liquid to the upstream side based on the specified position of the outer edge of the processing liquid when it is determined that the abnormality has occurred.

9. The substrate processing apparatus according to any one of claims 1 to 8, wherein the controlling portion specifies a type of the processing liquid based on the captured image.

10. The substrate processing apparatus according to any one of claims 1 to 9,
wherein the near-infrared light source includes a plurality of near-infrared light sources emitting near-infrared rays having peak wavelengths different from each other, and
wherein the controlling portion
acquires type information indicating the type of the processing liquid and
changes the near-infrared light source that irradiates a region including the tip of the processing liquid nozzle based on the acquired type information.

11. A substrate processing method comprising:
a step of holding a substrate and rotating the substrate;
a step of supplying a processing liquid to a processing liquid nozzle and supplying the processing liquid from the processing liquid nozzle to an upper surface of the substrate;
a step of returning the processing liquid in the processing liquid nozzle to an upstream side after stopping the supply of the processing liquid;
a step of irradiating a region including a tip of the processing liquid nozzle with near-infrared rays;
a step of generating a captured image obtained by capturing an image of the processing liquid irradiated with the near-infrared rays and moving to the upstream side in the processing liquid nozzle; and
a step of specifying a position of an outer edge of the processing liquid in the processing liquid nozzle based on the captured image.

12. The substrate processing method according to claim 11, wherein in the step of specifying step, a position of an end edge of the processing liquid on a downstream side in the processing liquid nozzle is specified based on the captured image.

13. The substrate processing method according to claim 12, comprising a step of calculating a speed at which the processing liquid moves to an upstream side in the processing liquid nozzle based on the specified position of the end edge of the processing liquid on the downstream side.

14. The substrate processing method according to claim 13,
wherein in the step of generating the captured image, an image of the processing liquid moving to the upstream side in the processing liquid nozzle is captured when a predetermined time has elapsed since the processing liquid in the processing liquid nozzle starts to be returned to the upstream side, and
in the step of calculating, the speed is calculated based on the specified position of the end edge of the processing liquid on the downstream side and the predetermined time.

15. The substrate processing method according to claim 14,
wherein in the step of calculating,
a distance from a tip of the processing liquid nozzle to the end edge of the processing liquid on the downstream side is calculated based on the captured image, and
the speed is calculated based on the calculated distance and the predetermined time.

16. The substrate processing method according to claim 13,
wherein in the step of generating the captured image , an image of the processing liquid moving to the upstream side in the processing liquid nozzle is captured a plurality of times at predetermined time intervals, and
in the step of calculating, the speed is calculated based on a position of the end edge of the processing liquid on the downstream side in a plurality of the captured images and the predetermined time.

17. The substrate processing method according to any one of claims 14 to 16,
wherein in the step of specifying, a center line of a liquid flow path through which the processing liquid passes in the processing liquid nozzle is specified based on the captured image, and
in the step of calculating, the speed is calculated based on a length of movement of the end edge of the processing liquid on the downstream side along the center line of the liquid flow path and the predetermined time.

18. The substrate processing method according to any one of claims 11 to 17, comprising:
a step of determining the presence or absence of occurrence of abnormality based on the specified position of the outer edge of the processing liquid; and
a step of changing at least one of a timing of starting returning of the processing liquid to the upstream side and a timing of stopping the returning of the processing liquid to the upstream side based on the specified position of the outer edge of the processing liquid when it is determined that the abnormality has occurred.

19. The substrate processing method according to any one of claims 11 to 18, wherein in the step of specifying, a type of the processing liquid is specified based on the captured image.

20. The substrate processing method according to any one of claims 11 to 19,
wherein the near-infrared light source includes a plurality of near-infrared light sources configured to emit near-infrared rays having peak wavelengths different from each other, and
wherein the substrate processing method comprises:
a step of acquiring type information indicating the type of the processing liquid;
a step of changing the near-infrared light source that irradiates a region including the tip of the processing liquid nozzle based on the acquired type information.
